(19) Europäisches Patentamt
European Patent Office
Office européen des brevets

(11) **EP 3 086 135 B1**

(12) **FASCICULE DE BREVET EUROPEEN**

(45) Date de publication et mention
de la délivrance du brevet:
**29.07.2020 Bulletin 2020/31**

(21) Numéro de dépôt: **16166521.1**

(22) Date de dépôt: **22.04.2016**

(51) Int Cl.:
*G01R 35/00* (2006.01)   *G01R 19/25* (2006.01)
*G01D 3/08* (2006.01)   *G01D 4/00* (2006.01)
*H02J 13/00* (2006.01)

(54) **PROCÉDÉ DE DÉTECTION D'UNE MESURE DÉFECTUEUSE D'UNE GRANDEUR ÉLECTRIQUE EXTENSIVE**

VERFAHREN ZUR DETEKTION EINER FEHLERHAFTEN MESSUNG EINER EXTENSIVEN ELEKTRISCHEN GRÖSSE

DETECTION METHOD OF A DEFECTIVE MEASUREMENT OF AN EXTENSIVE ELECTRIC QUANTITY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **23.04.2015 FR 1553641**

(43) Date de publication de la demande:
**26.10.2016 Bulletin 2016/43**

(73) Titulaire: **Schneider Electric Industries SAS**
**92500 Rueil-Malmaison (FR)**

(72) Inventeurs:
• **LIGERET, Christophe**
**38050 GRENOBLE Cedex 09 (FR)**
• **CLOT, Sylvain**
**38050 GRENOBLE Cedex 09 (FR)**
• **DESCHAMPS, Philippe**
**38050 GRENOBLE Cedex 09 (FR)**

(74) Mandataire: **Lavoix**
**62, rue de Bonnel**
**69448 Lyon Cedex 03 (FR)**

(56) Documents cités:
**EP-A1- 1 348 970      US-A1- 2012 221 265**
**US-A1- 2014 214 218**

**Description**

La présente invention concerne un procédé de détection d'une mesure défectueuse d'une grandeur électrique extensive.

Dans le domaine de la distribution d'électricité, il est connu d'assurer la distribution de courant à une pluralité de consommateurs électriques via un réseau électrique de distribution comprenant une arrivée électrique amont, un poste de transformation électrique, notamment un transformateur HT-MT (haute tension - moyenne tension) ou un transformateur MT-BT (moyenne tension - basse tension), et plusieurs départs électriques aval. Chaque départ électrique aval est une ligne moyenne tension ou basse tension et est configuré pour assurer la distribution de courant vers un consommateur.

Dans un tel réseau électrique de distribution, il est souhaitable de connaitre une ou plusieurs grandeurs électriques, telles que l'énergie, la puissance ou le courant, de l'arrivée amont et de chaque départ aval. Un processus de contrôle sur le réseau électrique peut ainsi être créé puisque l'arrivée et les départs sont surveillés. Pour ce faire, il est connu d'équiper l'arrivée amont, ainsi que chaque départ aval d'un ou plusieurs capteurs de mesure. Ces capteurs définissent une chaîne de mesure de la grandeur électrique souhaitée et sont configurés pour réaliser une mesure de manière synchrone les uns avec les autres.

Or, un dysfonctionnement d'un capteur de mesure, positionné en amont ou en aval, invalide tout le processus de contrôle sur le réseau électrique. En effet, un capteur défectueux ne permet pas d'identifier un défaut ou un dysfonctionnement du réseau électrique, ce qui peut avoir des conséquences importantes sur le fonctionnement du réseau et la distribution d'électricité.

Le document US 2014/214218-A1 est également connu de l'état de la technique.

Le but de l'invention est donc de proposer un procédé de détection d'une mesure défectueuse qui permet de signaler de manière sûre, fiable et rapide la présence d'un dysfonctionnement sur un capteur de mesure.

A cet effet, l'invention a pour objet un procédé selon la revendication 1. Il s'agit d'un procédé de détection d'une mesure défectueuse d'au moins une grandeur électrique extensive d'un réseau électrique comprenant une arrivée amont et au moins deux départs aval, l'arrivée et les départs étant pourvus chacun d'un capteur de mesure de la grandeur électrique extensive, chaque capteur réalisant, de manière synchrone avec les autres capteurs, une mesure de la grandeur électrique extensive en fonction d'un paramètre p, le procédé étant caractérisé en ce qu'il comprend au moins N mesures de la valeur sur l'arrivée amont et sur chaque départ aval réalisées pour différentes valeurs du paramètre p, et en ce qu'une fois les mesures faites :

a) on formalise la relation entre les mesures, pour chaque valeur du paramètre p avec l'équation :

$$M\left(p_j\right) = \sum_{i=1}^{N} a_i m_i(p_j)$$

où j est un indice du paramètre p, $M(p_j)$ est une mesure du capteur de l'arrivée amont pour une valeur $p_j$ du paramètre, N est le nombre de départs aval, i est indice de départ aval variant de 1 à N, $m_i(p_j)$ est une mesure du capteur du départ aval d'indice i pour la valeur $p_j$ du paramètre et $a_i$ est un gain de cette mesure ;

b) on crée un système à N équations et N inconnues, les inconnues étant les gains $a_i$ ;

c) on résout le système d'équations, en calculant chaque gain $a_i$ ;

d) on contrôle les gains $a_i$ et :

- si tous les gains sont égaux à 1, on considère qu'aucun capteur n'a réalisé une mesure défectueuse ;
- si au moins un des gains $a_i$ est différent de 1, on considère qu'au moins un capteur a réalisé une mesure défectueuse.

Grâce à l'invention, chaque capteur de mesure est surveillé à l'aide d'un gain, c'est-à-dire une valeur numérique, qui permet d'identifier de manière univoque la présence d'une mesure défectueuse au sein d'un capteur du réseau électrique. Le calcul des gains est relativement simple car il nécessite de résoudre un système linéaire d'ordre N, ce qui est réalisable facilement et à bas coût par un microprocesseur.

Selon d'autres aspects avantageux de l'invention, le procédé de détection comprend en outre une ou plusieurs des caractéristiques suivantes, prises isolément ou selon toutes les combinaisons techniquement admissibles :

- on identifie un capteur qui a réalisé une mesure défectueuse pour le paramètre via le gain qui lui est associé.
- lorsqu'un gain est différent de 1, le capteur auquel il est associé est considéré comme ayant réalisé une mesure défectueuse.

- une valeur corrigée de la mesure défectueuse est définie à partir de l'équation :

$$m'_k\left(p_j\right) = M\left(p_j\right) - \sum_{i=1, i \neq k}^{N} m_i(p_j)$$

où $m'_k$ est la mesure corrigée pour la valeur $p_j$ du paramètre, k étant l'indice compris entre 1 et N du gain différent de 1.
- lorsque tous les gains ont une valeur identique et différente de 1, le capteur de l'arrivée amont est considérée comme ayant réalisé une mesure défectueuse.
- une valeur corrigée de la mesure défectueuse est définie à partir de l'équation suivante :

$$M'_k\left(p_j\right) = \sum_{i=1}^{N} m_i\left(p_j\right)$$

où $M'(p_j)$ est la mesure corrigée pour la valeur $p_j$ du paramètre k.
- on diagnostique le type de défaut du capteur qui a réalisé la mesure défectueuse.
- lorsque le gain de la mesure défectueuse varie entre deux ou plusieurs mesures pour des valeurs différentes du paramètre, le défaut est identifié comme aléatoire.
- lorsque le gain de la mesure défectueuse reste constant entre deux ou plusieurs mesures pour des valeurs différentes du paramètre, le défaut est identifié comme structurel et inhérent au capteur.
- lorsque le gain de la mesure défectueuse présente une valeur négative pour plusieurs mesures pour des valeurs différentes du paramètre, le défaut est identifié comme étant dû au fait que le capteur est monté à l'envers sur le départ aval correspondant.
- un gain corrigé est défini à partir de l'équation :

$$a'_k = \frac{1}{a_k}$$

où k est un indice compris entre 1 et N, $a_k$ est le gain associé à la mesure défectueuse et $a'_k$ est le gain corrigé.
- le réseau électrique est un réseau électrique polyphpasé incluant un nombre H de phases électriques, H étant un nombre entier supérieur ou égal à deux, ce réseau électrique comportant un groupe de H arrivées amont et, pour chaque phase électrique, au moins deux départs aval, les arrivées amont et chaque départ comportant un capteur de mesure de la grandeur électrique extensive en fonction du paramètre p et en ce que, l'étape a) est appliquée pour chaque phase électrique, pour formaliser la relation entre les mesures des capteurs de cette phase électrique, afin de détecter un défaut d'un capteur associé à cette phase électrique.
- on identifie les capteurs qui ont réalisé une mesure défectueuse en contrôlant les gains des mesures des capteurs associés à au moins deux phases distinctes du réseau électrique.
- lorsque le gain d'une première mesure défectueuse d'un capteur sur une phase électrique du réseau électrique et le gain d'une deuxième mesure défectueuse d'un autre capteur sur une autre phase électrique du réseau électrique sont égaux, respectivement au rapport des valeurs des deuxième et première mesures défectueuses et au rapport des valeurs des première et deuxième mesures défectueuses, alors le défaut est identifié comme étant dû à la permutation de ces deux capteurs entre ces phases différentes du réseau électrique.
- Le procédé comporte, en outre, la détermination d'un angle de phase pour chaque valeur mesurée par les capteurs d'une même phase électrique du réseau électrique, le capteur à l'origine de la mesure défaillante étant identifié comme celui qui présente une valeur d'angle de phase correspondant à la différence entre, d'une part, l'angle de phase associé à la mesure du capteur de l'arrivée amont et, d'autre part, la somme des angles de phase associés aux mesures des capteurs des départs aval pour cette phase électrique.

L'invention sera mieux comprise et d'autres avantages de celle-ci apparaitront plus clairement à la lumière de la description qui va suivre, donnée uniquement à titre d'exemple non limitatif, faite en référence aux dessins sur lesquels :

- la figure 1 est une représentation schématique d'un réseau électrique de distribution comprenant une arrivée amont, un poste d'alimentation et plusieurs départs aval;

- la figure 2 est un diagramme de gains $a_i$, lorsqu'un procédé conforme à l'invention est appliqué et qu'aucun capteur ne réalise une mesure défectueuse ;
- la figure 3 est un diagramme analogue à la figure 2, lorsqu'un capteur sur un départ aval réalise une mesure défectueuse ; et
- la figure 4 est un diagramme analogue à la figure 2, lorsque le capteur sur l'arrivée amont réalise une mesure défectueuse ;
- la figure 5 une représentation schématique d'un réseau électrique polyphasé de distribution comprenant un poste d'alimentation et, pour chaque phase de ce réseau électrique, une arrivée amont et plusieurs départs aval ;
- la figure 6 est un diagramme de Fresnel illustrant des valeurs vectorielles mesurées au sein du réseau électrique des figures 1 ou 5.

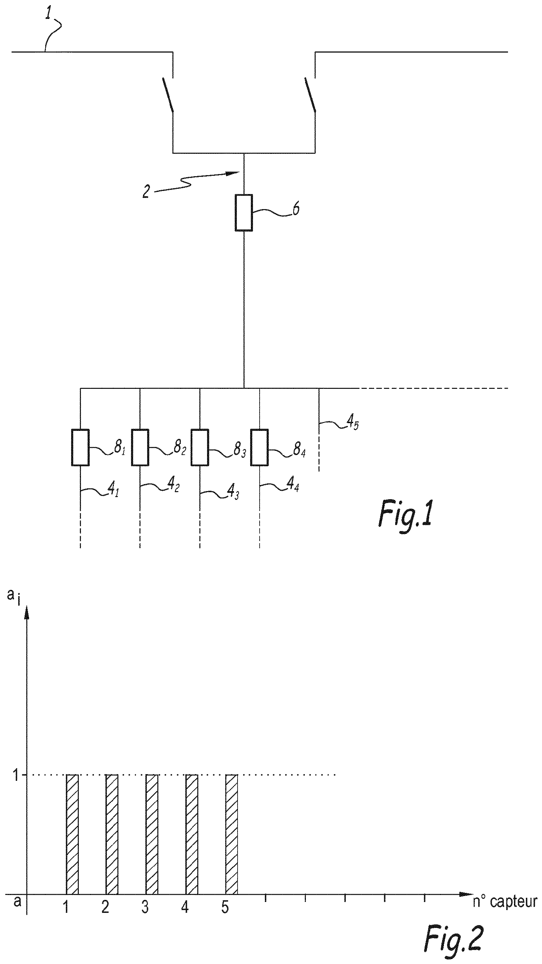

Sur la figure 1, un réseau électrique 1 de distribution, tel qu'un réseau électrique triphasé ou un réseau électrique monophasé, est configuré pour transmettre un courant électrique via un poste de transformation. On note 2 l'arrivée électrique du réseau 1 en amont et on note également 4 les départs électriques positionnés en aval. Le réseau 1 est une source d'alimentation en courant électrique pour les départs 4 . On considère N départs aval $4_i$, N étant un entier naturel supérieur ou égal à 2 et i un indice variant de 1 à N. Chaque départ aval $4_i$ est une ramification électrique configurée pour assurer la distribution de courant à un consommateur électrique.

L'arrivée amont 2 est pourvue d'un capteur 6 de mesure d'une grandeur électrique extensive du réseau 1, tel que le courant électrique. En variante, cette grandeur extensive peut être la puissance électrique, l'énergie électrique, le débit ou des harmoniques de ces grandeurs.

Chaque départ aval $4_i$ est également pourvu d'un capteur $8_i$ de mesure de la grandeur électrique. En pratique, N capteurs $8_i$ sont présents sur les N départs en aval 4.

Les capteurs de mesure 6 et $8_i$ sont homogènes et ils mesurent la même grandeur extensive qui, elle, se conserve. Dans l'exemple des figures 1 à 4, le paramètre p est le temps t et chaque valeur du paramètre p est un instant $t_j$ de temps, j étant un indice du paramètre p.

Les capteurs 6 et $8_i$ sont configurés pour réaliser, de manière synchrone l'un avec les autres, une mesure de la même grandeur électrique en fonction d'un paramètre p. En d'autres termes, avant de réaliser les mesures, les capteurs 6 et $8_i$ sont synchronisés par exemple, de manière radioélectrique. En pratique, le capteur 6 est apte à envoyer un signal radioélectrique de synchronisation temporelle aux capteurs $8_i$.

On note $M(t_j)$ une mesure réalisée par le capteur 6 de l'arrivée amont 2 à l'instant $t_j$ de temps. On note $m_i(t_j)$ une mesure réalisée par le capteur $8_i$ du départ aval $4_i$ au même instant $t_j$. En pratique, les N capteurs $8_i$ réalisent N mesures $m_i(t_j)$ à l'instant $t_j$ de temps.

Dans une configuration de fonctionnement normale des capteurs 6 et $8_i$, le courant étant une grandeur extensive, la somme des N mesures $m_i(t_j)$ des capteurs $8_i$ des départs aval $4_i$ correspond à la mesure $M(t_j)$ du capteur 6 de l'arrivée en amont 2. En d'autres termes, on peut décrire la relation entre ces mesures avec l'équation :

$$M(t_j) = \sum_{i=1}^{N} m_i(t_j) \qquad \text{(équation 1)}$$

L'équation 1 ci-dessus est valide exclusivement dans le cas où tous les capteurs 6 et $8_i$ ne présentent pas de défaut et réalisent des mesures M et $m_i$ correctes. L'équation 1, ainsi que toutes les équations successives, prennent en compte les imprécisions aléatoires, les erreurs et les incertitudes de mesure qui caractérisent tous les capteurs. L'équation 1 est alors satisfaite à moins d'une erreur aléatoire.

Au contraire, dans le cas où une ou plusieurs mesures réalisées est ou sont défectueuse(s), par exemple égale(s) à un pourcentage de la mesure correcte, l'équation 1 n'est pas valide.

Afin d'identifier la ou les mesures défectueuses, ainsi que le ou les capteurs défectueux, le procédé de détection de l'invention prend en compte un gain $a_i$ attribué à chaque mesure $m_i$ et formalise la relation entre les mesures pour chaque instant $t_j$, avec l'équation suivante :

$$M(t_j) = \sum_{i=1}^{N} a_i m_i(t_j) \qquad \text{(équation 2)}$$

où $a_i$ est le gain de la mesure $m_i$. Ce gain est constant au cours du temps.

L'équation 2 a N inconnues, c'est-à-dire les N valeurs de gain $a_i$.

De façon connue en soi, afin d'identifier N inconnues d'une équation, il est suffisant de formaliser un système à N équations. En d'autres termes, l'équation 2 étant issue d'une mesure synchrone réalisée par les capteurs 6 et $8_i$, il est suffisant de réaliser N mesures synchrones avec les capteurs 6 et 8, à N instants $t_j$ distincts. Une fois ces N mesures réalisées, il est algébriquement possible de résoudre le système d'équations et calculer chaque gain $a_i$.

Les gains $a_i$ étant calculés, on contrôle les valeurs de ces gains et, en fonction de ces valeurs, on peut identifier la présence d'une ou plusieurs mesures défectueuses M ou $m_i$.

En particulier, si toutes les gains $a_i$ sont égaux à 1, comme représenté à la figure 2, on considère qu'aucun capteur n'a réalisé une mesure défectueuse. En effet, lorsque les gains $a_i$ sont tous égaux à 1, l'équation 2 correspond, à moins d'une erreur aléatoire, à l'équation 1 qui est alors satisfaite.

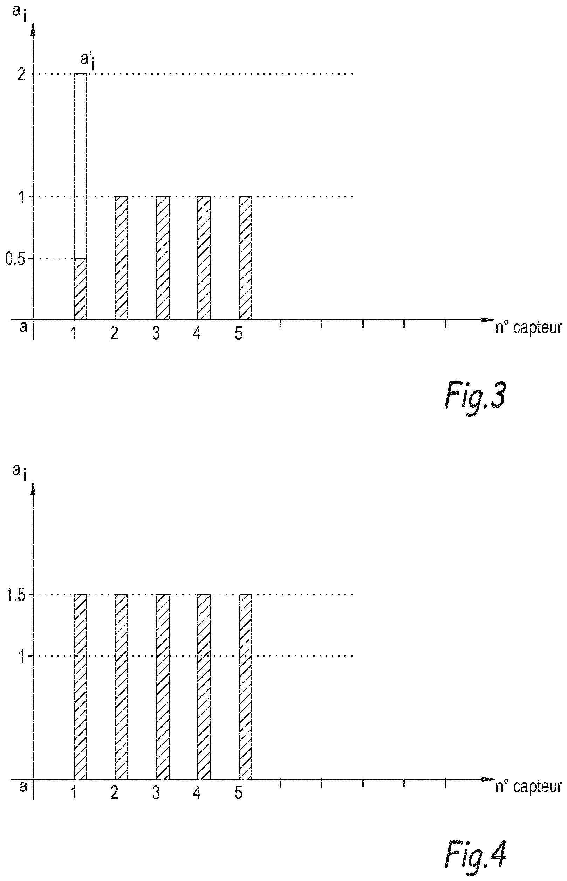

Au contraire, si au moins un gain $a_k$ (avec k indice compris entre 1 et N) parmi les gains $a_i$, est différent de 1, comme représenté à la figure 3 pour le gain $a_1$, on considère que le capteur $8_k$ a réalisé une mesure défectueuse $m_k$. A titre d'exemple non limitatif, dans l'exemple de la figure 3, le gain $a_1$ vaut 0,5. Cette valeur est aléatoire : le gain $a_1$ pourrait avoir tout autre valeur différente de 1, comme par exemple 2.

Egalement, si plusieurs gains $a_k$, $a_{k'}$...sont différents de 1, on considère que plusieurs capteurs $8_k$, $8_{k'}$... ont réalisé des mesures défectueuses $m_k$, $m_{k'}$,...

De plus, le procédé permet de localiser la ou les mesures défectueuses, c'est-à-dire qu'il permet de reconnaitre chaque capteur $8_k$ qui a réalisé une telle mesure défectueuse.

En effet, lorsqu'un gain $a_k$ est différent de 1, le capteur $8_k$ auquel il est associé est considéré comme ayant réalisé une mesure défectueuse $m_k$. Par exemple, comme représenté à la figure 3, lorsque le gain $a_1$ est différent de 1, on considère que le capteur $8_1$ du départ aval $4_1$ réalise la mesure défectueuse $m_1$.

Lorsque tous les gains $a_i$ ont une valeur identique et différente de 1, comme représenté à la figure 4, le capteur 6 de l'arrivée en amont 2 est considéré comme ayant réalisé une mesure défectueuse M. Dans l'exemple de la figure 4, les gains $a_i$ valent 1,5.

En effet, si on note a la probabilité qu'un capteur $8_i$ soit défaillant, la probabilité que tous les capteurs $8_i$ sur les départs $4_i$ soient défaillants en même temps est égale à $a^{N(1-a)}$. Par ailleurs, la probabilité que le capteur amont 6 soit défaillant est alors égale à $ax(1-a)^N$. Donc, si la résolution du système de N équations 2 a pour résultat que tous les gains $a_i$ sont différents de 1, on considère que le capteur 6 est en défaut.

En outre, le procédé de détection permet de définir une correction d'une mesure défectueuse réalisée M ou $m_k$ par le capteur 6 ou $8_k$.

En particulier, lorsque la mesure défectueuse $m_k(t_j)$ est réalisée à l'instant $t_j$ par un capteur $8_k$ d'un départ aval $4_k$, une valeur corrigée $m'_k(t_j)$ de la mesure $m_k(t_j)$ est calculée à partir de l'équation suivante :

$$m'_k\left(t_j\right) = M\left(t_j\right) - \sum_{i=1, i \neq k}^{N} m_i(t_j) \qquad \text{(équation 3)}$$

où $m'_k(t_j)$ est la mesure corrigée à l'instant $t_j$.

Lorsque la mesure défectueuse $M(t_j)$ est réalisée par le capteur 6 de l'arrivée amont 2, le procédé propose une valeur corrigée $M'(t_j)$ de la mesure défectueuse qui est définie à partir de l'équation suivante :

$$M'\left(t_j\right) = \sum_{i=1}^{N} m_i\left(t_j\right) \qquad \text{(équation 4)}$$

où $M'_k(t_j)$ est la mesure corrigée à l'instant $t_j$.

Le procédé de détection diagnostique également le type de défaut du capteur 6 ou $8_k$ qui a réalisé la mesure défectueuse M ou $m_k$, cela grâce aux gains $a_i$. En effet, lorsque le gain $a_k$ de la mesure défectueuse $m_k$ varie entre deux ou plusieurs mesures pour des instants $t_j$ différents, le défaut est identifié comme aléatoire. En pratique, une mesure défectueuse et aléatoire peut être un pourcentage de la mesure correcte. Une mesure défectueuse et aléatoire peut également être un bruit de fond.

Au contraire, lorsque le gain $a_k$ de la mesure défectueuse $m_k$ reste constant entre deux ou plusieurs mesures pour des instants $t_j$ différents, le défaut est identifié comme structurel. En pratique, dans ce cas, le capteur peut délivrer, de façon constante, une valeur 0, une valeur qui varie de façon proportionnelle avec le gain $a_k$ ou une valeur de fond d'échelle, c'est-à-dire la valeur maximale que peut rendre le capteur $8_k$.

Le procédé de détection permet également de définir un gain corrigé $a'_k$ à partir de l'équation suivante :

$$a'_k = \frac{1}{a_k} \qquad \text{(équation 5)}$$

où k est l'indice compris entre 1 et N et $a_k$ est le gain associé à la mesure défectueuse $m_k$.

Le gain corrigé $a'_k$ étant calculé, le procédé permet de calculer une mesure correcte $m_i$ à l'instant $t_j$ à partir de

la relation suivante :

$$m_i(t_j) = a'_k \times a_k \times m_k(t_j) \qquad \text{(équation 6)}$$

Ainsi, dans le cas représenté à la figure 3 où le capteur $8_1$ est repéré comme ne délivrant que 50% de la valeur réelle du courant sur le départ $4_1$, un gain corrigé $a'_1$ égal à 2, soit 1/0,5, est appliqué sur les valeurs délivrées par le capteur $8_1$.

Le paramètre p, en fonction duquel les capteurs 6 et $8_i$ réalisent leurs mesures, peut également être une ou plusieurs harmoniques qui composent les mesures.

Quel que soit le mode de réalisation du procédé de l'invention, il est possible de réaliser un nombre N' de mesures strictement supérieur au nombre N des inconnues. De cette façon, le procédé de détection permet d'améliorer la robustesse du calcul des gains $a_i$.

Dans les modes de réalisation et variantes envisagés, les étapes de procédé sont mises en œuvre de façon automatique par une unité électronique qui comprend un automate, par exemple de type microprocesseur.

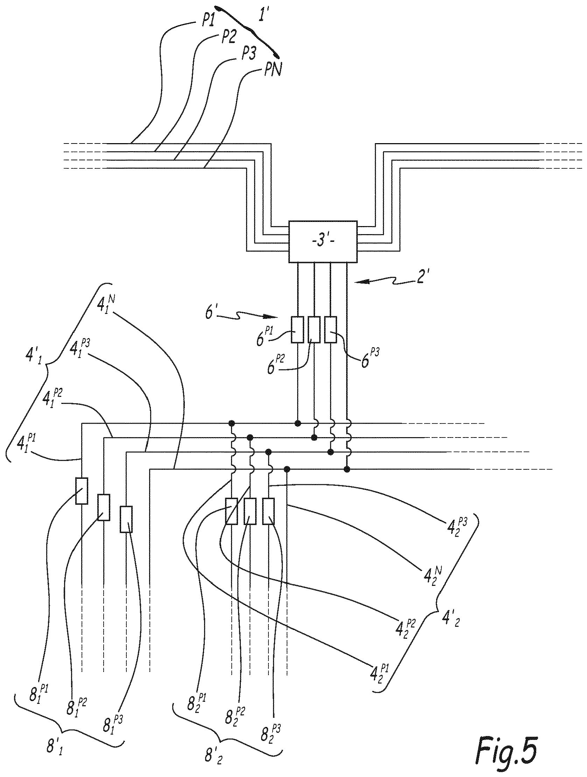

La figure 5 se rapporte à un autre mode de réalisation du réseau 1. Sur cette figure 5, les éléments analogues à ceux du réseau 1 portent les mêmes références. De même, tout ce qui est décrit en référence au paramètre « p » s'applique également ici.

La figure 5 représente un réseau de distribution électrique 1' polyphasé, comportant un nombre H de phases électriques, H étant un nombre supérieur ou égal à 2. Dans cet exemple, le réseau 1' est un réseau triphasé et comporte à cet effet trois phases électriques P1, P2 et P3 distinctes, chacune associée à un conducteur électrique distinct. Le réseau 1' comporte également une phase électrique neutre, notée PN.

De façon analogue au réseau 1, le réseau 1' est configuré pour transmettre un courant électrique via un poste de transformation 3.

Par exemple, chacune des H phases du réseau 1', c'est-à-dire ici les phases P1, P2, P3 et PN, est agencée de la même façon que le réseau 1 lorsque le réseau 1 est un réseau monophasé. Ainsi, tout ce qui est précédemment décrit en référence au réseau 1 s'applique au réseau formé par chacune de ces H phases.

On note 2' un groupe d'arrivées électriques amont du réseau 1 en amont et on note $4'_i$ un groupe de départs électriques positionnés en aval, pour « i » compris entre 1 et N. Tout ce qui est précédemment décrit en référence à l'arrivée électrique 2 et aux départs électriques 4 s'applique respectivement aux arrivées électriques amont du groupe 2' et aux départs électriques aval des groupes $4'_i$, en particulier en ce qui concerne l'utilisation de l'indice i pour identifier les groupes $4'_i$. Le nombre N désigne ici le nombre de groupes $4'_i$. et correspond au nombre de départs aval $4_i^h$ pour chaque phase.

On note $4_1^{P1}$, $4_1^{P2}$ et $4_1^{P3}$ les départs correspondant aux phases P1, P2 et P3 et $4_1^N$ le départ correspondant à la phase neutre PN pour un premier groupe aval $4'_1$. De même, note $4_2^{P1}$, $4_2^{P2}$ et $4_2^{P3}$ les départs correspondant aux phases P1, P2 et P3 et $4_2^N$ le départ correspondant à la phase neutre PN pour un deuxième groupe aval $4'_2$. Pour simplifier la figure 5, seuls deux groupes $4'_1$, et $4'_2$ sont illustrés. Les groupes $4'_1$, et $4'_2$ permettent chacun d'acheminer un courant triphasé à destination d'un abonné du réseau 1'.

Chacune des phases P1, P2, P3 du réseau 1' est pourvue, au niveau du groupe 2', d'un capteur amont de mesure, analogue au capteur 6, pour mesurer une grandeur électrique extensive du réseau 1'. Cette grandeur électrique est ici le courant électrique, bien qu'en variante, cette grandeur extensive peut être la puissance électrique, l'énergie électrique, le débit ou des harmoniques de ces grandeurs. On note $6^{P1}$ le capteur amont associé à la phase P1, $6^{P2}$ le capteur amont associé à la phase P2 et $6^{P3}$ le capteur amont associé à la phase P3. Dans ce qui suit, ces capteurs sont référencés de façon générale $6^h$, où l'indice h identifie la phase correspondante. Ici, h est égal à l'une des phases P1, P2 ou P3.

Ces capteurs $6^h$ forment un ensemble 6' de capteurs amont du réseau 1'. Ici, aucun capteur $6^h$ n'est placé sur la phase neutre N.

Chacune des phases P1, P2, P3 du réseau 1' est également pourvue, au niveau de chaque groupe $4'_i$ d'un capteur aval de mesure de la grandeur électrique, analogue aux capteurs $8_i$ précédemment décrits. On note $8_i^{P1}$ le capteur amont aval associé à la phase P1, $8_i^{P2}$ le capteur amont associé à la phase P2 et $8_i^{P3}$ le capteur amont associé à la phase P3 pour le groupe $4'_i$, pour « i » compris entre 1 et N. Dans ce qui suit, ces capteurs sont référencés $8_i^h$, où l'indice h identifie la phase correspondante comme précédemment indiqué. Pour chaque groupe $4'_i$, ces capteurs forment un ensemble $8'_i$ de capteurs aval du réseau 1'.

Les capteurs des ensembles 6' et $8'_i$ jouent respectivement le même rôle, vis-à-vis du réseau 1', que les capteurs de mesure 6 et $8_i$ précédemment décrits pour le réseau 1.

On note $M^h(t_j)$ une mesure réalisée par le capteur $6^h$, $m_i^h(t_j)$ une mesure réalisée par le capteur $8_i^h$ et $a_i^h$ le gain associé à la mesure $m_i^h(t_j)$, ce gain $a_i^h$ étant défini de manière analogue au gain $a_i$ défini précédemment.

Les procédés décrits en référence au réseau 1 s'appliquent également ici pour chacune des phases P1, P2 et P3. Ainsi, pour chacune des phases P1, P2 et P3, l'équation suivante est formalisée pour chaque instant $t_i$ :

$$M^h(t_j) = \sum_{i=1}^{N} a_i^h m_i^h(t_j) \qquad \text{(équation 7)}$$

L'équation 7 a N inconnues, c'est-à-dire les N valeurs de gain de $a_i^h$. En appliquant l'équation 7 pour chacune des phases P1, P2 et P3, on obtient un système d'équations à 3 x N inconnues, qui est ici résolu de façon analogue à la résolution du système d'équations précédemment décrit en référence au réseau 1.

En outre, le procédé est mis en œuvre en tenant compte simultanément de mesures provenant de différentes phases entre elles, pour détecter des erreurs de mesure. Ce procédé permet plus particulièrement de détecter une erreur de pose d'un ou de plusieurs des capteurs $8_i^h$.

Dans un premier exemple, le procédé permet avantageusement de détecter si un des capteurs $8_i^h$ est monté à l'envers sur le conducteur électrique formant le départ $4_i^h$. En effet, les capteurs $8_i^h$ présentent généralement un sens de montage précis qui doit être respecté lorsqu'ils sont installés dans le réseau 1'. Ce procédé s'applique également au réseau 1 pour détecter si un des capteurs $8_i$ est monté à l'envers sur un départ $4_i$.

A titre d'exemple illustratif et non limitatif, on considère le cas où le capteur $8_1^{P1}$ est monté à l'envers sur le départ $4_1^{P1}$, c'est-à-dire qu'une partie du capteur $8_1^{P1}$ normalement orientée suivant une première direction, est ici orientée à tort vers une direction opposée. Ce capteur $8_1^{P1}$ retourne alors une valeur de mesure $m_1^{P1}(t_j)$ de signe opposé à la mesure qu'il devrait normalement retourner. La mesure $m_1^{P1}(t_j)$ est alors dite défectueuse. Le gain $a_1^{P1}$ de ce capteur $8_1^{P1}$ est donc égal à « -1 ». Un gain corrigé $a'_1^{P1}$ égal à $1/a_1^{P1}$ est utilisable pour corriger la mesure renvoyée par le capteur $8_1^{P1}$, comme indiqué précédemment.

Ainsi, pour la phase P1, la relation suivante est satisfaite :

$$M^{P1}(t_j) - \sum_{i=1}^{N} a_i^{P1} m_i^{P1}(t_j) = 2 \times m_1^{P1}(t_j) \qquad \text{(équation 8)}$$

Lorsqu'aucun des autres capteurs ne présente de défaut, la relation de l'équation 7 est respectée pour les autres phases P2 et P3.

Le procédé identifie donc la présence du défaut sur une phase en vérifiant que l'équation 7 n'est pas satisfaite et que l'équation 8 est satisfaite puis identifie le capteur à l'origine du défaut en rapprochant la valeur de mesure $m_1^{P1}(t_j)$ de la valeur du second membre de l'équation 8. Le défaut est ici identifié comme étant dû au montage à l'envers du capteur $8_1^{P1}$ du fait que le gain $a_1^{P1}$ présente une valeur négative, par exemple pour plusieurs instants $t_j$, de préférence pour tous les instants $t_j$ de mesure.

Dans un deuxième exemple, le procédé permet avantageusement de détecter que deux capteurs $8_i^h$ d'un même groupe $4'_i$ sont par erreur permutés entre eux, c'est-à-dire fixés chacun sur un conducteur électrique associé à un départ d'une des H phases différent de celui sur lequel il aurait normalement dû être placé.

A titre d'exemple non limitatif, on considère le cas où les capteurs $8_1^{P1}$ et $8_1^{P2}$ sont ici permutés entre les phases P1 et P2 au niveau du départ $4_1$. Plus précisément, le capteur $8_1^{P1}$ est monté sur le départ $4_1^{P2}$ au lieu d'être monté sur le départ $4_1^{P1}$. Le capteur $8_1^{P2}$ est monté sur le départ $4_2^{P1}$ au lieu d'être monté sur le départ $4_1^{P2}$. Ainsi, le capteur $8_1^{P1}$ retourne la valeur de mesure $m_1^{P2}(t_j)$ et le capteur $8_1^{P2}$ retourne la valeur de mesure $M_1^{P1}(t_j)$. Les mesures $m_1^{P2}(t_j)$ et $m_1^{P1}(t_j)$ sont alors dites défectueuses.

Ces mesures défectueuses sont détectées du fait que, pour les phases P1 et P2 sur lesquelles se trouvent les capteurs $8_1^{P1}$ et $8_1^{P2}$ incriminés et pour plusieurs instants $t_j$ de mesure, de préférence pour tous les instants $t_j$ de mesure, l'égalité de l'équation 7 n'est pas satisfaite mais, à la place, la relation suivante est satisfaite :

$$M^{P1}(t_j) - \sum_{i=1}^{N} a_i^{P1} m_i^{P1}(t_j) = -\left(M^{P1}(t_j) - \sum_{i=1}^{N} a_i^{P2} m_i^{P2}(t_j)\right) \qquad \text{(équation 9)}$$

Au contraire, lorsqu'aucun des autres capteurs ne présente de défaut, la relation de l'équation 7 est respectée pour la phase P3.

Le gain $a_1^{P1}$ est donc égal à « $m_1^{P2}(t_j) / m_1^{P1}(t_j)$ » et le gain $a_1^{P2}$ est égal à « $m_1^{P1}(t_j) / m_1^{P2}(t_j)$ ».

Dans un troisième exemple, le procédé permet avantageusement de détecter si un des capteurs $8_i^h$ est monté par erreur sur la phase neutre d'un groupe $4'_i$, au lieu d'être monté sur l'un des conducteurs électriques associés à un départ $4_i^h$ d'une des H phases.

A titre d'exemple non limitatif, on considère le cas où le capteur $8_1^{P3}$ est monté par erreur sur le départ $4_1^N$ associé au neutre PN du groupe $4'_1$ au lieu d'être monté sur le départ $4_1^{P3}$ associé à la phase P3. Le capteur $8_1^{P3}$

réalise donc une mesure défectueuse.

Il est connu que, dans un réseau électrique polyphasé, la valeur de la grandeur électrique dans la phase neutre peut être reconstituée à partir des valeurs mesurées de la même grandeur électrique dans les autres phases présentes aux côtés du neutre. On utilise donc de telles valeurs reconstituées à partir des valeurs mesurées par les capteurs $6^h$ et $8_i^h$. Dans le cas du réseau triphasé 1', ces valeurs reconstituées sont calculées comme suit :

$$M^{PN}(t_j) = -\left(M^{P1}(t_j) + M^{P2}(t_j) + M^{P3}(t_j)\right) \qquad \text{(équation 10)}$$

$$m_i^{PN}(t_j) = -\left(m_i^{P1}(t_j) + m_i^{P2}(t_j) + m_i^{P3}(t_j)\right) \qquad \text{(équation 11)}$$

La mesure défectueuse est détectée du fait que la valeur $M^{PN}(t_j)$ n'est pas égale à la somme des valeurs $m_i^{PN}(t_j)$ et que, pour la phase P3 sur laquelle se trouve le capteur incriminé, l'égalité de l'équation 7 n'est pas satisfaite et, à la place, la relation suivante est satisfaite :

$$M^{P3}(t_j) \neq \sum_{i=1}^{N} a_i^{P3} m_i^{P3}(t_j) \qquad \text{(équation 12)}$$

Lorsqu'aucun des autres capteurs ne présente de défaut, la relation de l'équation 7 est respectée pour les autres phases P1 et P2.

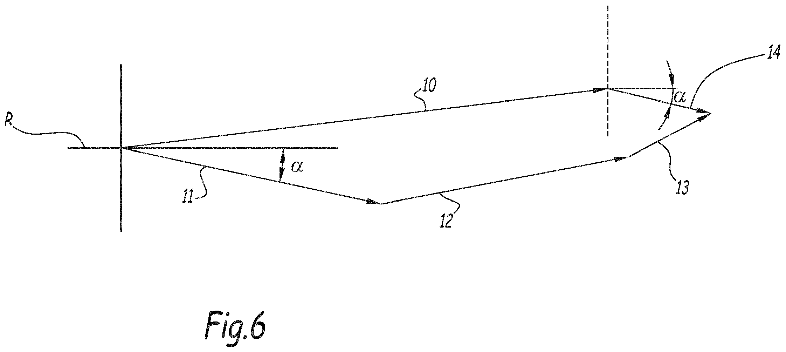

La figure 6 se rapporte à une autre application avantageuse du procédé utilisé dans le réseau 1'. Le procédé permet de détecter la présence d'une erreur de mesure constante de type écart, ou « offset » en langue anglaise. Dans un tel cas de figure, pour l'un des capteurs associé à une phase donnée, une valeur d'erreur s'ajoute de façon constante au cours du temps à la valeur mesurée par ce capteur. Le procédé précédemment décrit est mis en œuvre pour identifier l'existence d'une mesure erronée.

Pour identifier le départ $4'_i$ sur lequel est placé le capteur défaillant, il est possible de mesurer l'angle de phase associé à l'écart entre la mesure $M^h(t_j)$ et la somme des mesures $m_i^h(t_j)$ pour cette phase, et de comparer cet écart à chacun des angles de phases associés aux mesures $m_i^h(t_j)$ pour cette phase.

Dans cet exemple illustratif, on considère le cas où le réseau électrique comporte trois départs $4_i^h$ ici pour une seule et même phase h. La figure 6 illustre des mesures effectuées par les capteurs $6^h$ et $8_i^h$ de ce réseau, sous forme vectorielle selon un diagramme de Fresnel et par rapport à un repère R prédéfini.

Plus précisément, le vecteur 10 correspond à la mesure $M(t_j)$ effectuée par le capteur de tête 6 de cette même phase. Les vecteurs 11, 12 et 13 correspondent respectivement aux valeurs des mesures $m_i^h(t_j)$ effectuées par les capteurs $8_i^h$ associés aux trois départs pour cette phase. Le vecteur 14 correspond à la différence vectorielle, ou écart, entre le vecteur 10 et la somme des vecteurs 11, 12 et 13. On note $\alpha$ l'angle de phase associé à la valeur de l'écart, c'est-à-dire au vecteur 14, et défini par rapport au repère R. Cet angle $\alpha$ est comparé avec chacun des angles des vecteurs 10, 11, 12 et 13 définis par rapport au même repère R. L'angle $\alpha$ est ici égal a différence entre d'une part l'angle de phase associé à la mesure du capteur $6_i$ de l'arrivée amont et, d'autre part, la somme des angles de phase associés aux mesures des capteurs $8_i^h$ des départs aval pour cette phase électrique.

Le capteur à l'origine du défaut est identifié comme étant celui qui présente un angle de phase électrique correspondant à l'angle $\alpha$ associé à l'écart. Par « correspondant », on entend ici que l'angle de phase électrique est égal, de préférence à 2% près, encore plus préférentiellement à 5% près, et modulo 180°, à l'angle $\alpha$ associé à l'écart. Ici, c'est le vecteur 11 qui a un angle de phase égal à l'angle $\alpha$, ce qui traduit le fait que c'est le capteur $8^h_1$ du départ $4_i^h$ qui est défaillant.

Lorsqu'aucun capteur ne correspond à l'angle de phase associé à l'écart mais que cet angle est égal à l'angle de phase associé la mesure $M(t_j)$ effectuée par le capteur de tête 6, alors le capteur de tête 6 est dit être défaillant. En effet, la probabilité que tous les capteurs $8_i$ ou $8_i^h$ de cette phase soient défaillants simultanément, au même instant de mesure $t_j$ et avec le même offset, est extrêmement faible.

Les modes de réalisation et les variantes envisagés ci-dessus peuvent être combinés entre eux pour générer de nouveaux modes de réalisation de l'invention.

## Revendications

1. Procédé de détection d'une mesure défectueuse (M, $m_k$) d'au moins une grandeur électrique extensive d'un réseau électrique (1 ; 1') comprenant une arrivée amont (2) et au moins deux départs aval ($4_i$ ; $4_i^h$), l'arrivée et les départs étant pourvus chacun d'un capteur (6, $8_i$ ; $6^h$, $8_i^h$) de mesure de la grandeur électrique extensive, chaque capteur réalisant, de manière synchrone avec les autres capteurs, une mesure de la grandeur électrique extensive en fonction d'un paramètre p, le paramètre p étant :

- soit le temps t, chaque valeur du paramètre p étant un instant $t_i$,
- soit une ou plusieurs harmoniques qui composent une mesure,

le procédé comprenant au moins N mesures de la valeur sur l'arrivée amont (2) et sur chaque départ aval ($4_i$) réalisées pour différentes valeurs du paramètre p,
le procédé étant **caractérisé en ce qu'**une fois les mesures faites :

a) on formalise la relation entre les mesures, pour chaque valeur du paramètre p avec l'équation :

$$M(p_j) = \sum_{i=1}^{N} a_i m_i(p_j)$$

où j est un indice du paramètre p, $M(p_j)$ est une mesure du capteur (6 ; $6^h$) de l'arrivée amont (2) pour une valeur $p_j$ du paramètre, N est le nombre de départs aval ($4_i$), i est indice de départ aval variant de 1 à N, $m_i(p_j)$ est une mesure du capteur (8 ; $8_i^h$) du départ aval ($4_i$) d'indice i pour la valeur $p_j$ du paramètre et $a_i$ est un gain de cette mesure ;
b) on crée un système à N équations et N inconnues, les inconnues étant les gains $a_i$ ;
c) on résout le système d'équations, en calculant chaque gain $a_i$ ;
d) on contrôle les gains $a_i$ et :

- si tous les gains ($a_i$) sont égaux à 1, on considère qu'aucun capteur (6, $8_i$ ; $6^h$, $8_i^h$) a réalisé une mesure défectueuse ;
- si au moins un ($a_k$) des gains $a_i$ est différent de 1, on considère qu'au moins un capteur a réalisé une mesure défectueuse (M, $m_k$).

2. Procédé selon la revendication 1, **caractérisé en ce qu'**on identifie un capteur (6, 8 ; $6^h$, $8_i^h$) qui a réalisé une mesure défectueuse (M, $m_k$) pour le paramètre ($p_j$) via le gain ($a_i$) qui lui est associé.

3. Procédé selon la revendication 2, **caractérisé en ce que**, lorsqu'un gain ($a_i$) est différent de 1, le capteur ($8_i$ ; $8_i^h$) auquel il est associé est considéré comme ayant réalisé une mesure défectueuse ($m_k$).

4. Procédé selon la revendication 3, **caractérisé en ce qu'**une valeur corrigée de la mesure défectueuse ($m_k$) est définie à partir de l'équation :

$$m'_k(p_j) = M(p_j) - \sum_{i=1, i \neq k}^{N} m_i(p_j)$$

où $m'_k(p_j)$ est la mesure corrigée pour la valeur $p_j$ du paramètre, k étant l'indice compris entre 1 et N du gain ($a_k$) différent de 1.

5. Procédé selon la revendication 2, **caractérisé en ce que**, lorsque tous les gains ($a_i$) ont une valeur identique et différente de 1, le capteur (6 ; $6^h$) de l'arrivée amont (2) est considérée comme ayant réalisé une mesure défectueuse (M).

6. Procédé selon la revendication 5, **caractérisé en ce qu'**une valeur corrigée de la mesure défectueuse (M) est définie à partir de l'équation suivante :

$$M'_k\left(p_j\right) = \sum_{i=1}^{N} m_i\left(p_j\right)$$

où M'($p_j$) est la mesure corrigée pour la valeur $p_j$ du paramètre k.

7. Procédé selon l'une des revendications précédentes, **caractérisé en ce qu'**on diagnostique le type de défaut du capteur (6, $8_i$ ; $6^h$, $8_i^h$) qui a réalisé la mesure défectueuse (M, $m_k$).

8. Procédé selon la revendication 7, **caractérisé en ce que**, lorsque le gain ($a_k$) de la mesure défectueuse ($m_k$) varie entre deux ou plusieurs mesures pour des valeurs ($p_j$) différentes du paramètre, le défaut est identifié comme aléatoire.

9. Procédé selon la revendication 7, **caractérisé en ce que**, lorsque le gain ($a_k$) de la mesure défectueuse ($m_k$) reste constant entre deux ou plusieurs mesures pour des valeurs ($p_j$) différentes du paramètre, le défaut est identifié comme structurel et inhérent au capteur (6, $8_i$ ; $6^h$, $8_i^h$).

10. Procédé selon la revendication 9, **caractérisé en ce que**, lorsque le gain ($a_k$) de la mesure défectueuse ($m_k$) présente une valeur négative pour plusieurs mesures pour des valeurs ($p_j$) différentes du paramètre, le défaut est identifié comme étant dû au fait que le capteur ($8_i$ ; $8_i^h$) est monté à l'envers sur le départ aval ($4_i$ ; $4_i^h$) correspondant.

11. Procédé selon la revendication 9 ou 10, **caractérisé en ce qu'**un gain corrigé est défini à partir de l'équation :

$$a'_k = \frac{1}{a_k}$$

où k est un indice compris entre 1 et N, $a_k$ est le gain associé à la mesure défectueuse et $a'_k$ est le gain corrigé.

12. Procédé selon l'une des revendications précédentes, **caractérisé en ce que** le réseau électrique (1') est un réseau électrique polyphpasé incluant un nombre H de phases électriques (P1, P2, P3), H étant un nombre entier supérieur ou égal à deux, ce réseau électrique (1') comportant un groupe (2') de H arrivées amont et, pour chaque phase électrique (P1, P2, P3), au moins deux départs aval ($4_i^h$), les arrivées amont et chaque départ ($4_i^h$) comportant un capteur ($6^h$, $8_i^h$) de mesure de la grandeur électrique extensive en fonction du paramètre p et **en ce que**, l'étape a) est appliquée pour chaque phase électrique (P1, P2, P3), pour formaliser la relation entre les mesures des capteurs de cette phase électrique, afin de détecter un défaut d'un capteur associé à cette phase électrique.

13. Procédé selon la revendication 12, **caractérisé en ce qu'**on identifie les capteurs ($8_i^h$) qui ont réalisé une mesure défectueuse en contrôlant les gains ($a_i^h$) des mesures ($m_i^h(t_j)$) des capteurs associés à au moins deux phases distinctes du réseau électrique (1').

14. Procédé selon la revendication 13, **caractérisé en ce que**, lorsque le gain ($a_1^{P1}$) d'une première mesure défectueuse d'un capteur ($8_1^{P1}$) sur une phase électrique (P1) du réseau électrique (1') et le gain ($a_1^{P2}$) d'une deuxième mesure défectueuse d'un autre capteur ($8_1^{P2}$) sur une autre phase électrique (P2) du réseau électrique (1') sont égaux, respectivement au rapport des valeurs des deuxième et première mesures défectueuses ($m_1^{P2}(t_j)$ / $m_1^{P1}(t_j)$) et au rapport des valeurs des première et deuxième mesures défectueuses ($m_1^{P1}(t_j)$ / $m_1^{P2}(t_j)$), alors le défaut est identifié comme étant dû à la permutation de ces deux capteurs entre ces phases différentes du réseau électrique (1').

15. Procédé selon la revendication 10, **caractérisé en ce qu'**il comporte, en outre, la détermination d'un angle de phase pour chaque valeur (M, $m_i$) mesurée par les capteurs ($8_i$ ; $8_i^h$) d'une même phase électrique du réseau électrique, le capteur à l'origine de la mesure défaillante étant identifié comme celui qui présente une valeur d'angle de phase (a) correspondant à la différence entre, d'une part, l'angle de phase associé à la mesure du capteur (6 ; $6^h$) de l'arrivée amont et, d'autre part, la somme des angles de phase associés aux mesures des capteurs ($8_i$ ; $8_i^h$) des départs aval pour cette phase électrique.

**Patentansprüche**

1. Verfahren zum Erfassen einer fehlerhaften Messung (M, $m_k$) mindestens einer extensiven elektrischen Größe eines elektrischen Netzes (1;

1'), das eine stromaufwärts gelegenen Zuleitung (2) und mindestens zwei stromabwärts gelegene Abzweigungen ($4_i$; $4_i^h$) umfasst, wobei die Zuleitung und die Abzweigungen jeweils mit einem Sensor (6, $8_i$; $6^h$, $8_i^h$) zur Messung der extensiven elektrischen Größe versehen sind und jeder Sensor synchron mit den anderen Sensoren eine Messung der extensiven elektrischen Größe abhängig von einem Parameter p durchführt, wobei der Parameter p ist:

- sei es die Zeit t, wobei jeder Wert des Parameter p ein Zeitpunkt $t_i$ ist,
- sei es eine oder mehrere Harmonische, die eine Messung zusammensetzen,

wobei das Verfahren mindestens N Messungen des Wertes an der stromaufwärts gelegenen Zuleitung (2) und an jeder stromabwärts gelegenen Abzweigung ($4_i$), die für unterschiedliche Werte des Parameters p durchgeführt werden, umfasst,
wobei das Verfahren **dadurch gekennzeichnet ist, dass** sobald die Messungen durchgeführt wurden:

a) die Beziehung zwischen den Messungen für jeden Wert des Parameters p mit der Gleichung formalisierten wird:

$$M(p_j) = \sum_{i=1}^{N} a_i m_i(p_j)$$

wobei j ein Index des Parameters p ist, M ($p_j$) eine Messung des Sensors (6; $6^h$) der stromaufwärts gelegenen Zuleitung (2) für einen Wert $p_j$ des Parameter ist, N die Anzahl von stromabwärts gelegenen Abzweigungen ($4_i$) ist, i ein Index der stromabwärts gelegenen Abzweigung, die von 1 bis N variiert, ist, $m_i$ ($p_j$) eine Messung des Sensors ($8_i$; $8_i^h$) der stromabwärts gelegenen Abzweigung ($4_i$) des Index i für den Wert $p_j$ des Parameters ist und $a_i$ eine Verstärkung dieser Messung ist;
b) ein System mit N Gleichungen und N Unbekannten erzeugt wird, wobei die Unbekannten die Verstärkungen ai sind;
c) das Gleichungssystem gelöst wird, wobei jede Verstärkung ai berechnet wird;
d) die Verstärkungen $a_i$ überprüft werden und:

- wenn alle Verstärkungen ($a_i$) gleich 1 sind, bestimmt wird, dass kein Sensor (6, $8_i$; $6^h$, $8_i^h$) eine fehlerhafte Messung durchgeführt hat;
- wenn mindestens eine ($a_k$) der Verstärkungen $a_i$ unterschiedlich zu 1 ist, bestimmt wird, dass mindestens ein Sensor eine fehlerhafte Messung (M, $m_k$) durchgeführt hat.

2. Verfahren nach Anspruch 1, **dadurch gekennzeichnet, dass** ein Sensor (6, $8_i$; $6^h$, $8_i^h$), der eine fehlerhafte Messung (M, $m_k$) für den Parameter ($p_j$) durchgeführt hat, über die Verstärkung ($a_i$), die ihm zugeordnet ist, identifiziert wird.

3. Verfahren nach Anspruch 2, **dadurch gekennzeichnet, dass**, wenn eine Verstärkung ($a_i$) unterschiedlich zu 1 ist, der Sensor($8_i$; $8_i^h$), dem sie zugeordnet ist, angesehen wird, als habe er eine fehlerhafte Messung ($m_k$) durchgeführt.

4. Verfahren nach Anspruch 3, **dadurch gekennzeichnet, dass** ein korrigierter Wert der fehlerhaften Messung ($m_k$) nach der Gleichung definiert wird:

$$m'_k(p_j) = M(p_j) - \sum_{i=1, i \neq k}^{N} m_i(p_j)$$

wobei $m'_k(p_j)$ die für den Wert $p_j$ des Parameters korrigierte Messung ist, k der Index zwischen 1 und N der zu 1 unterschiedlichen Verstärkung ($a_k$) ist.

5. Verfahren nach Anspruch 2, **dadurch gekennzeichnet, dass**, wenn alle Verstärkungen ($a_i$) einen identischen Wert unterschiedlich zu 1 haben, der Sensor ($6$; $6^h$) der stromaufwärts gelegenen Zuleitung (2) angesehen wird, als habe er eine fehlerhafte Messung (M) durchgeführt.

6. Verfahren nach Anspruch 5, **dadurch gekennzeichnet, dass** ein korrigierter Wert der fehlerhaften Messung (M) nach der folgenden Gleichung definiert wird:

$$M'_k(p_j) = \sum_{i=1}^{N} m_i(p_j)$$

wobei M'($p_j$) die für den Wert $p_j$ des Parameters k korrigierte Messung ist.

7. Verfahren nach einem beliebigen der vorhergehenden Ansprüche, **dadurch gekennzeichnet, dass** die Art des Fehlers des Sensors ($6$, $8_i$; $6^h$, $8_i^h$), der die fehlerhafte Messung (M, $m_k$) durchgeführt hat, diagnostiziert wird.

8. Verfahren nach Anspruch 7, **dadurch gekennzeichnet, dass**, wenn die Verstärkung ($a_k$) der fehlerhaften Messung ($m_k$) zwischen zwei oder mehreren Messungen für unterschiedliche Werte ($p_j$) des Parameters variiert, der Fehler als zufallsbedingt identifiziert wird.

9. Verfahren nach Anspruch 7, **dadurch gekennzeichnet, dass**, wenn die Verstärkung ($a_k$) der fehlerhaften Messung ($m_k$) zwischen zwei oder mehreren Messungen für unterschiedliche Werte ($p_j$) des Parameters konstant bleibt, der Fehler als strukturell und dem Sensor ($6$, $8_i$; $6^h$, $8_i^h$) inhärent identifiziert wird.

10. Verfahren nach Anspruch 9, **dadurch gekennzeichnet, dass**, wenn die Verstärkung ($a_k$) der fehlerhaften Messung ($m_k$) für mehrere Messungen für unterschiedliche Werte ($p_j$) des Parameters einen negativen Wert aufweist, der Fehler identifiziert wird als der Tatsache geschuldet, dass der Sensor ($8_i$; $8_i^h$) verkehrt herum an der entsprechenden Abzweigung ($4_i$; $4_i^h$) montiert ist.

11. Verfahren nach Anspruch 10, **dadurch gekennzeichnet, dass** eine korrigierte Verstärkung durch die Gleichung definiert ist:

$$a'_k = \frac{1}{a_k}$$

wobei k ein Index zwischen 1 und N ist, $a_k$ die der fehlerhaften Messung zugeordnete Verstärkung ist und $a'_k$ die korrigierte Verstärkung ist.

12. Verfahren nach einem der vorhergehenden Ansprüche, **dadurch gekennzeichnet, dass** das elektrischen Netz (1') ein mehrphasiges Netz ist, das eine Anzahl H von elektrischen Phasen (P1, P2, P3) einschließt, wobei H eine ganze Zahl größer oder gleich zwei ist, dieses elektrischen Netz (1') eine Gruppe (2') von H stromaufwärts gelegenen Zuleitungen und für jede elektrische Phase (P1, P2, P3) mindestens zwei stromabwärts gelegene Abzweigungen ($4_i^h$) aufweist, wobei die stromaufwärts gelegenen Zuleitungen und jede Abzweigung ($4_i^h$) einen Sensor ($6^h$, $8_i^h$) zum Messen der extensiven elektrischen Größe abhängig vom Parameter p aufweist, und dass der Schritt a) für jede elektrische Phase (P1, P2, P3) angewandt wird, um die Beziehung zwischen den Messungen der Sensoren dieser elektrische Phase zu formalisierten, damit ein Fehler eines dieser elektrischen Phase zugeordneten Sensors detektiert wird.

13. Verfahren nach Anspruch 12, **dadurch gekennzeichnet, dass** die Sensoren ($8_i^h$), die eine fehlerhafte Messung durchgeführt haben, identifiziert werden, indem die Verstärkungen ($a_i^h$) der Messungen ($m_t^h(t_j)$) der zugeordneten Sensoren, die mindestens zwei unterschiedlichen Phasen des elektrischen Netzes (1') zugeordnet sind, überprüft werden.

14. Verfahren nach Anspruch 13, **dadurch gekennzeichnet, dass**, wenn die Verstärkung ($a_1^{P1}$) einer ersten fehlerhaften Messung eines Sensors ($8_1^{P1}$) an einer elektrischen Phase (P1) des elektrischen Netzes (1') und die Ver-

stärkung($a_1^{P2}$) einer zweiten fehlerhaften Messung eines anderen Sensors ($8_1^{P2}$) an einer anderen elektrischen Phase (P2) des elektrischen Netzes (1') jeweils gleich dem Verhältnis der Werte der zweiten und ersten fehlerhaften Messung ($m_i^{P2}(t_j)$/ $m_1^{P1}(t_j)$) und dem Verhältnis der Werte der ersten und zweiten fehlerhaften Messung ($m_1^{P1}(t_j)$/ $m_1^{P2}(t_j)$) sind, dann wird der Fehler identifiziert als der Vertauschung der zwei Sensoren zwischen diesen unterschiedlichen Phasen des elektrischen Netzes (1') geschuldet.

15. Verfahren nach Anspruch 10, **dadurch gekennzeichnet, dass** es außerdem die Bestimmung eines Phasenwinkels für jeden von den Sensoren ($8_i$; $8_i^h$) gemessenen Wert einer selben elektrischen Phase des elektrischen Netzes aufweist, wobei der Sensor am Ursprung der fehlerhaften Messung identifiziert wird als derjenige, der einen Wert des Phasenwinkels ($\alpha$) aufweist, der der Differenz zwischen einerseits dem Phasenwinkel, der der Messung des Sensors (6; $6^h$) der stromaufwärts gelegenen Zuleitung zugeordnet ist, und andererseits der Summe der Phasenwinkel, die den Messungen der Sensoren ($8_i$; $8_i^h$) der stromabwärts gelegenen Abzweigungen für diese elektrische Phase zugeordnet sind, entspricht.

**Claims**

1. A method for detecting a faulty measurement ($M$, $m_k$) of at least one extensive electric quantity of an electric network (1 ;1') comprising an upstream supply (2) and at least two downstream outlets ($4_i$ ; $4_i^h$), the supply and the outlets being each provided with a sensor (6, $8_i$; $6^h$, $8_i^h$) for measuring the extensive electric quantity, each sensor conducting, in a synchronous way with the other sensors, a measurement of the extensive electric quantity depending on a parameter p,
the parameter p being :

   - either the time t, each value of the parameter p being a time instant $t_j$,
   - or one or several harmonics which make up a measurement the method comprising at least N measurements of the value on the upstream supply (2) and on each downstream outlet ($4_i$) conducted for different values of the parameter p, the method being **characterized in that** once the measurements have been made:

      a) the relationship between the measurements is formalized, for each value of the parameter p with the equation:

$$M(p_j) = \sum_{i=1}^{N} a_i m_i(p_j)$$

      wherein j is an index of the parameter p, $M(p_j)$ is a measurement of the sensor (6 ; $6^h$) of the upstream supply (2) for a value $p_j$ of the parameter, N is the number of downstream outlets ($4_i$), i is the downstream outlet initial index varying from 1 to N, $m_i(p_j)$ is a measurement from the sensor ($8_i$ ; $8_i^h$) of the downstream outlet ($4_i$) of index i for the value $p_j$ of the parameter and $a_i$ is a gain of this measurement;
      b) a system of N equations and N unknowns is generated, the unknowns being the gains $a_i$;
      c) the system of equations is solved, by calculating each gain $a_i$;
      d) the gains $a_i$ are controlled and:

         - if all the gains ($a_i$) are equal to 1, it is considered that no sensor (6, $8_i$; $6^h$, $8_i^h$) has conducted a faulty measurement;
         - if at least one ($a_k$) of the gains $a_i$ is different from 1, it is considered that at least one sensor has conducted a faulty measurement ($M$, $m_k$).

2. The method according to claim 1, **characterized in that** a sensor (6, 8 ; $6^h$, $8_i^h$) which has conducted a faulty measurement ($M$, $m_k$) for the parameter ($p_j$) is identified via the gain ($a_i$) which is associated with it.

3. The method according to claim 2, **characterized in that** when a gain ($a_i$) is different from 1, the sensor ($8_i$; $8_i^h$) with which it is associated is considered as having conducted a faulty measurement ($m_k$).

4. The method according to claim 3, **characterized in that** a corrected value of the faulty measurement ($m_k$) is defined from the equation:

$$m'_k\left(p_j\right) = M\left(p_j\right) - \sum_{i=1, i\neq k}^{N} m_i(p_j)$$

wherein $m'_k(p_j)$ is the corrected measurement for the value $p_j$ of the parameter, k being the index comprised between 1 and N of the gain ($a_k$) different from 1.

5. The method according to claim 2, **characterized in that**, when all the gains ($a_i$) have an identical value and different from 1, the sensor (6 ; $6^h$) of the upstream supply (2) is considered as having conducted a faulty measurement (M).

6. The method according to claim 5, **characterized in that** a corrected value of the faulty measurement (M) is defined from the following equation:

$$M'_k\left(p_j\right) = \sum_{i=1}^{N} m_i\left(p_j\right)$$

wherein M'($p_j$) is the corrected measurement for the value $p_j$ of the parameter k.

7. The method according to one of the preceding claims, **characterized in that** the type of fault of the sensor (6, $8_i$; $6^h$, $8_i^h$) which has conducted the faulty measurement (M, $m_k$) is diagnosed.

8. The method according to claim 7, **characterized in that**, when the gain ($a_k$) of the faulty measurement ($m_k$) varies between two or several measurements for different values ($p_j$) of the parameter, the fault is identified as a random fault.

9. The method according to claim 7, **characterized in that**, when the gain ($a_k$) of the faulty measurement ($m_k$) remains constant between two or several measurements for different values ($p_j$) of the parameter, the fault is identified as a structural default and inherent to the sensor (6, $8_i$ ; $6^h$, $8_i^h$).

10. The method according to claim 9, **characterized in that**, when the gain ($a_k$) of the faulty measurement ($m_k$) has a negative value for several measurements for different values ($p_j$) of the parameter, the fault is identified as being due to the fact that the sensor ($8_i$; $8_i^h$) is mounted upside down on the corresponding downstream outlet ($4_i$ ; $4_i^h$).

11. The method according to claim 9 or 10, **characterized in that** a corrected gain is defined from the equation:

$$a'_k = \frac{1}{a_k}$$

wherein k is an index comprised between 1 and N, $a_k$ is the gain associated with the faulty measurement and a'k is the corrected gain.

12. The method according to one of the preceding claims, **characterized in that** the electric network (1') is a multiphase electric network including a number H of electric phases (P1, P2, P3), H being an integer greater than or equal to two, this electric network (1') including a group (2') of H upstream supplies and, for each electric phase (P1, P2, P3), at least two downstream outlets ($4_i^h$), the upstream supplies and each outlet ($4_i^h$) including a sensor ($6^h$, $8_i^h$) for measuring the extensive electric quantity depending on the parameter p and **in that**, the step a) is applied for each electric phase (P1, P2, P3), in order to formalize the relationship between the measurements of the sensors of this electric phase, in order to detect a fault of a sensor associated with this electric phase.

13. The method according to claim 12, **characterized in that** the sensors ($8_i^h$) which have conducted a faulty measurement are identified by controlling the gains ($a_i^h$) of the measurements ($m_i^h(t_j)$) from the sensors associated with at least two distinct phases of the electric network (1').

14. The method according to claim 13, **characterized in that**, when the gain ($a_1^{P1}$) of a first faulty measurement of a sensor ($8_1^{P1}$) on an electric phase (P1) of the electric network (1') and the gain ($a_1^{P2}$) of a second faulty measurement

of another sensor $(8_1{}^{P2})$ on another electric phase (P2) of the electric network (1') are equal, respectively to the ratio of the values of the second and first faulty measurements $(m_1{}^{P2}(t_j) / m_1{}^{P1}(t_j))$ and to the ratio of the values of the first and second faulty measurements $(m_1{}^{P1}(t_j) / m_1{}^{P2}(t_j))$, then the fault is identified as being due to the swapping of both of these two sensors between these different phases of the electric network (1').

15. The method according to claim 10, **characterized in that** it further includes, the determination of a phase angle for each value $(M, m_i)$ measured by the sensors $(8_i ; 8_i{}^h)$ of a same electric phase of the electric network, the sensor at the origin of the faulty measurement being identified as the one which has a value of a phase angle $(\alpha)$ corresponding to the difference between the phase angle associated with the measurement of the sensor $(6 ; 6^h)$ of the upstream supply on the one hand and the sum of the phase angles associated with the measurements of the sensors $(8_i; 8_i{}^h)$ of the downstream outlets for this electric phase on the other hand.

Fig.1

Fig.2

*Fig.3*

*Fig.4*

Fig.5

18

*Fig.6*

**EP 3 086 135 B1**

## RÉFÉRENCES CITÉES DANS LA DESCRIPTION

**Documents brevets cités dans la description**

- US 2014214218 A1